# EUROPÄISCHE PATENTSCHRIFT

(11) **EP 2 003 709 B1**
(45) Veröffentlichungstag und Bekanntmachung des Hinweises auf die Patenterteilung: **23.01.2013**
(21) Anmeldenummer: 07011397.2
(22) Anmeldetag: 11.06.2007
(51) Int. Cl.: H01L 41/107, H01L 41/04

(54) **Piezokonverter mit Primärregelung und zugehöriger Piezotransformator**
Piezo converter with primary automatic control and pertinent piezo transformer
Piezo-convertisseur à régulation primaire et piezo-transformateur

(43) Veröffentlichungstag der Anmeldung: 17.12.2008
(73) Patentinhaber: Power Systems Technologies GmbH, 48346 Ostbevern (DE)
(72) Erfinder: Bothe, Michael, 63500 Seligenstadt (DE); Mörbe, Stefan, 49205 Hasbergen (DE)
(74) Vertreter: Grünecker, Kinkeldey, Stockmair & Schwanhäusser

(56) Entgegenhaltungen:
- WO-A1-98/50966
- DE-A1- 3 040 916
- DE-A1-102005 047 368
- FR-A- 2 503 492
- US-A- 3 657 579
- US-A- 3 689 781

## Beschreibung

Die vorliegende Erfindung bezieht sich auf auf Schaltnetzteile, die einen Piezotransformator als Teil eines Piezokonverters beinhalten.

Piezotransformatoren sind Spannungswandler, die Mehrschichtaufbauten aus piezoelektrischer Keramik aufweisen.

Elektromagnetische Transformatoren auf der Basis von gewickelten Spulen wurden in der Vergangenheit häufig zum Erzeugen von Hochspannung wie auch zum Erzeugen von Niederspannung verwendet. Solche elektromagnetische Transformatoren besitzen einen elektrischen Leiter, der auf einen Kern aus einem ferromagnetischen Material gewickelt ist. Da für ein großes Spannungsübertragungsverhältnis eine große Anzahl von Windungen erforderlich sind, sind elektromagnetische Transformatoren mit ausreichender Effektivität meist nur schwer in miniaturisierter Form herstellbar. Darüber hinaus hat ein elektromagnetischer Transformator in Hochfrequenzanwendungen viele Nachteile, insbesondere aufgrund des magnetischen Materials, wie beispielsweise Anstieg des Hystereseverlusts, Wirbelstromverluste oder Skineffektverluste in dem Leiter. Diese Verluste begrenzen den praktisch realisierbaren Frequenzbereich magnetischer Transformatoren auf ca. 500 kHz.

Um diese und weitere Probleme des elektromagnetischen Transformators zu überkommen, wurden piezoelektrische Keramiktransformatoren, häufig als PT bezeichnet bezeichnet, entwickelt, die den piezoelektrischen Effekt ausnutzen. Im Gegensatz zu elektromagnetischen Transformatoren besitzen piezoelektrische Transformatoren eine genau begrenzte Frequenzcharakteristik des Verhältnisses der Ausgangsspannung zur Eingangsspannung, wobei das Maximum bei der Resonanzfrequenz liegt. Diese Resonanzfrequenz hängt von den Materialkonstanten und der Dicke des Materials sowohl von dem gesamten Transformator wie auch von dem piezolektrischen Material und den eingesetzten Elektroden ab.

Piezoelektrische Transformatoren besitzen eine Anzahl Vorteile gegenüber den bekannten elektromagnetischen Transformatoren. Insbesondere kann bei vergleichbarem Transformationsverhältnis der piezoelektrische Transformator wesentlich kleiner aufgebaut werden als ein elektromagnetischer Transformator. Darüber hinaus können piezoelektrische Transformatoren unbrennbar konstruiert werden und erzeugen kein elektromagnetisch induziertes Rauschen.

Die keramischen Körper, die für piezoelektrische Transformatoren verwendet werden, können in verschiedenen Formen und Gestalten realisiert werden, z. B. als Ringe, flache Platten und dergleichen. Verschiedene Bauformen piezoelektrischer Transformatoren sind beispielsweise in den Patentschriften US 6,362,559, US 6,346,764 oder US 6,326,718 beschrieben. Eine bekannte Ausgestaltung eines piezoelektrischen Transformators umfasst eine piezoelektrische keramische Scheibe mit kreisförmigem Aufbau, wobei segmentierte Elektroden auf einer oder beiden Seiten der Scheibe angeordnet sind.

Aus der US 2,830,274 ist ein piezoelektrischer Transformator des sogenannten "Rosentyps" bekannt, der in verschiedenen Ausführungsformen existiert. Der typische Rosentyp-PT umfasst eine flache keramische Platte, die wesentlich länger als breit ist und wesentlich breiter als dick. Hier werden die Vorteile eines piezoelektrischen Transformators gegenüber einem magnetischen Transformator besonders deutlich. Ein piezoelektrischer Transformator kann, wie bereits erwähnt, kompakter aufgebaut werden als ein magnetischer Transformator und hat als weiteren Vorteil die einfachere Skalierbarkeit hin zu geringeren Leistungen.

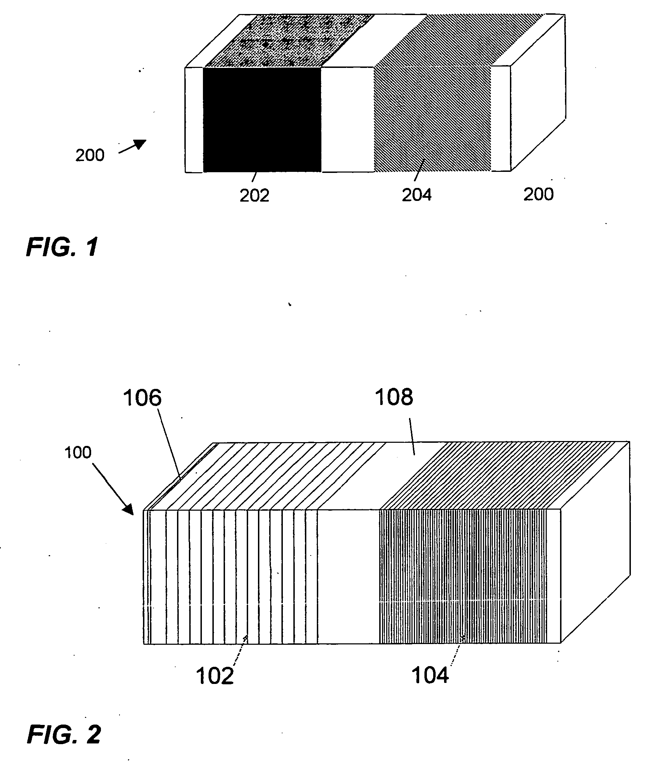

Bei den bekannten piezoelektrischen Transformatoren wird eine mehrlagige Elektrodenanordnung mit verschiedenartig segmentierten Primär- und Sekundärelektroden verwendet, wie sie in Figur 1 schematisch dargestellt wird.

Insbesondere im Zusammenhang mit Schaltnetzteilen bietet ein derartiger piezoelektrischer Transformator ein interessantes Potential zur Minimierung der Abmessungen eines solchen Schaltnetzteils, wie dies insbesondere in Zusammenhang mit portablen Geräten von großer Bedeutung ist.

Für Stromversorgungen im Kleinleistungsbereich, d. h. für Leistungen unter 100 Watt, insbesondere unter 10 Watt, werden heutzutage überwiegend Schaltnetzteile anstelle veralteter 50 Hz Linearnetzgeräte eingesetzt. Der Vorteil der Schaltnetzteiltechnik besteht dabei zunächst in der verringerten Baugröße und dem verringerten Gewicht des Geräts, verglichen mit einem Lineargerät.

Bei einem piezoelektrischen Transformator wird die Energie mittels mechanischer Schwingung von der Primär- auf die Sekundärseite übertragen. Piezoelektrische Transformatoren werden aus geeigneten Keramiken hergestellt und besitzen einen primärseitigen und einen sekundärseitigen Elektrodenbereich, wie dies in Figur 1 schematisch dargestellt ist.

Die Ausgangsspannung und der Ausgangsstrom eines Schaltnetzteils ist unabhängig von der Art des Transformators zumeist geregelt, d. h. die Ausgangspannung ist unabhängig von der zu versorgenden Last und bis zu einem maximalen Strom konstant. Bei Überschreiten der maximalen Last oder im Kurzschlussfall wird der Strom konstant gehalten und damit begrenzt. Die meisten geregelten Schaltnetzteile im Kleinleistungsbereich sind aus Kostengründen primärseitig geregelt, d. h. die Regeleinrichtung befindet sich auf der Primärseite des Schaltnetzteils.

In der Patentschrift DE 102 59 088 wird ein derartiges Schaltnetzteil mit piezoelektrischem Transformator beschrieben. Die Ausgangsspannung an einer veränderlichen Last wird hierbei durch Änderung der Arbeitsfrequenz und des Verhältnisses von ein Ein- und Ausschaltdauer konstant gehalten. Hierzu wird eine Information bezüglich des Ausgangsstroms von der Sekundärseite auf die Primärseite übertragen. Diese Übertragung muss, um die einschlägigen Normen einzuhalten, galvanisch getrennt erfolgen und es wird zumeist ein Optokoppler mit entsprechender Peripheriebeschaltung verwendet.

In den Patenten EP 1146630 und EP 1211794 wird ein primärseitig geregeltes Schaltnetzteil mit magnetischem Wandler beschrieben, bei dem die Ausgangsspannung mittels Pulsweitenmodulation konstant gehalten wird. Die Information über die Höhe der Ausgangsspannung wird mit Hilfe einer zusätzlichen Wicklungsanordnung auf dem Wandlertransformator gewonnen. An der Hilfswicklung kann bei diesen bekannten Regelschaltungen eine der Ausgangspannung proportionale Hilfsspannung abgegriffen werden. Die Hilfswicklung ist der Primärseite des Schaltnetzteils zugeordnet, daher wird keine zusätzlich galvanisch getrennte Übertragung mittels Optokoppler oder Signalübertragung von der Sekundärseite benötigt. Dies verringert die Anzahl der Bauteile und resultiert in erheblichen Kosteneinsparungen. Allerdings beinhalten solche bekannten primärseitig gesteuerten Schaltnetzteile immer noch einen elektromagnetischen Wandler mit all seinen oben genannten Nachteilen.

Die FR 2 503 492 offenbart einen piezoelektrischen Transformator mit Eingangselektroden, Ausgangselektroden und zusätzlichen Hilfselektroden zum Rückkoppeln an die Eingangsstufe. Dabei handelt es sich um an der Oberfläche des Grundkörpers angeordnete Flächenelektroden oder Kammstrukturen, wie dies beispielsweise aus den Figuren 5d, 6c, 6a und 6b hervorgeht, für einen Wandler, wie er in einem Relais oder einer Fernanzeige angewendet wird.

Die US 3,657,579 bezieht sich auf eine Spannungsversorgungsschaltung mit einem piezoelektrischen Spannungswandler, bei dem eine primäre Wechselspannung als primäre Rückkopplungsspannung in Phase mit der primären Wechselspannung zurückgekoppelt wird, um die Schwingung aufrecht zu erhalten, und es ist eine einzelne Hilfselektrode gezeigt. Grundsätzlich transformiert der Wandler eine niedrige Eingangswechselspannung in eine relativ hohe Ausgangswechselspannung.

Die DE 30 40 916 A1 bezieht sich auf eine Piezoansteuerungseinrichtung für Thyristoren und offenbart insbesondere einen Piezokoppler, der Eingangs- und Ausgangselektroden aufweist, und ein zusätzliches Elektrodenpaar als Rückkopplungselektrodenpaar besitzt. Allerdings sind bei dem hier gezeigten Piezokoppler nur Elektroden an der äußeren Oberfläche des piezoelektrischen Grundkörpers offenbart.

Die US 3,689,781 bezieht sich auf einen Spannungswandler mit einem piezoelektrischen Element, das ein Paar Treiberelektroden an einander gegenüberliegenden Außenseiten und eine Ausgangselektrode an einem Ende des Piezogrundkörpers aufweist. Eine Rückkopplungselektrode ist in der Nähe der Treiberelektroden angeordnet und eine Spannung von dieser Rückkopplungselektrode, die proportional zur Auslenkungsamplitude der Schwingung des piezoelektrischen Elements ist, wird an die Treiberquelle zurückgeführt, damit diese mit der Frequenz der mechanischen Schwingung des piezoelektrischen Elements schwingt.

In der DE 102005047368 A1 wird ein Transformator mit einem Grundkörper angegeben, der ein Material mit piezoelektrischen Eigenschaften wie z. B. Piezokeramik enthält. Der Grundkörper umfasst einen Eingangsteil und einen mechanisch mit diesem verbundenen Ausgangsteil. In den beiden Transformatorteilen sind Innenelektroden vorgesehen, die im Grundkörper angeordnet sind. Der Transformator umfasst ferner eine Hilfselektrode, die galvanisch vom Eingangsteil und vom Ausgangsteil und von den Innenelektroden getrennt ist. Im Eingangsteil des Transformators werden mit Hilfe elektrischer Spannungen mechanische Schwingungen im Körper des Transformators erzeugt. Im Ausgangsteil werden mechanische Schwingungen des Körpers in elektrische Felder umgewandelt, welche durch geeignete Elektroden abgegriffen werden können. Gemäß dieser Druckschrift ist mindestens ein Teil der Hilfselektrode parallel zu den Innenelektroden des Eingangsteils und des Ausgangsteils angeordnet. Im Grundkörper sind Innenelektroden angeordnet, die senkrecht auf der Polarisationsachse des Transformators stehen.

Die WO 98/50966 A1 bezieht sich auf eine Schaltung zum Treiben eines piezoelektrischen Transformators in einem phasenverriegelten Betriebsmodus ohne die Verwendung eines externen Referenzsignals. Die Schaltung verwendet eine Timerschaltung, die in einem stabilen Modus betrieben wird und durch ein Phasenrückkopplungssignal, das am Ausgang des piezoelektrischen Transformators abgegriffen wird, beeinflusst. Dieses Phasenrückkopplungssignal hat ein stärkeres Gewicht als die Triggerschaltung des Timers um die Phase des Timers mit dem Ausgang des piezoelektrischen Transformators bei einer Resonanzfrequenz des piezoelektrischen Transformators zu verriegeln. Auf diese Weise wird eine vereinfachte phasenverriegelte Schaltung ohne die typische PLL-Topologie vorgeschlagen.

Die Aufgabe, die der vorliegenden Erfindung zugrunde liegt, besteht darin, einen piezoelektrischen Transformator anzugeben, der in einem primärseitig gesteuerten Schaltnetzteil mit den Wirkprinzipien der Patentschriften EP 1146630 und EP 1211794 einsetzbar ist. Weiterhin liegt der vorliegenden Erfindung die Aufgabe zugrunde, eine zugehörige Ansteuerschaltung für ein solches Schaltnetzteil anzugeben.

Diese Aufgabe wird durch den Gegenstand des unabhängigen Patentanspruchs 1 gelöst. Vorteilhafte Weiterbildungen der vorliegenden Erfindung sind Gegenstand der abhängigen Patentansprüche.

Dabei basiert die vorliegende Erfindung auf der Idee, dass ein erhöhter Schaltungsaufwand im Vergleich zu elektromagnetischen Übertragern mit Hilfswicklung dadurch vermieden werden kann, dass die Übertragung der Information über die Ausgangsgröße, d. h. über die Ausgangsspannung, über den piezoelektrischen Transformator selbst erfolgt.

Die Regelung der Ausgangsspannung kann bei einem Schaltnetzteil mit piezoelektrischem Wandler durch Verändern der Arbeitsfrequenz erfolgen. Entfernt man sich von der Resonanzfrequenz des piezoelektrischen Transformators, so verringert sich die auf die Sekundärseite übertragene Energie. Um den Regelkreis zu schließen, muss die Regelgröße, in diesem Fall die Ausgangsspannung des Schaltnetzteils, galvanisch getrennt der Regeleinrichtung auf der Primärseite des Schaltnetzteils zugeführt werden. Erfindungsgemäß wird dies dadurch erreicht, dass eine weitere Elektrodenanordnung, eine sogenannte Hilfselektrodenanordnung, zusätzlich zu den Primär- und Sekundärelektrodenanordnungen in den piezoelektrischen Transformator integriert wird. Die Hilfselektrodenanordnung befindet sich gemäß einer vorteilhaften Weiterbildung der vorliegenden Erfindung auf der Primärseite des Piezotransformators.

Somit kann die abgegriffene Spannung direkt ohne galvanische Trennung dem Regler zugeführt werden.

An dem zusätzlich eingefügten Elektrodenpaar lässt sich ein der Ausgangsspannung proportionales Signal abgreifen, welches als Regelgröße für die primärseitig angeordnete Regeleinrichtung verwendet wird.

Gemäß einer weiteren vorteilhaften Ausführungsform der vorliegenden Erfindung wird die an der Hilfselektrodenanordnung abgegriffene Spannung einem Filter, insbesondere einem als Tiefpass ausgeführten Filter zugeführt, sodass nur die Grundschwingung des piezoelektrischen Transformators passieren kann. Oberschwingungen, die möglicherweise angeregt werden, können auf diese Weise herausgefiltert werden, sodass die Proportionalität zwischen der Ausgangsspannung und der an der Hilfselektrodenanordnung abgegriffenen Regelspannung verbessert wird.

Die an der zusätzlichen Hilfselektrodenanordnung abgegriffene Spannung ist abhängig vom Abstand dieser Elektroden und zudem proportional zu der mechanischen Spannung innerhalb des piezoelektrischen Transformators. Die mechanische Spannung ist über die ganze geometrische Länge des piezoelektrisches Transformators nicht konstant, sondern wird vielmehr durch eine Sinusfunktion beschrieben. Eine Änderung der Frequenz, mit welcher der Piezotransformator angeregt wird, hat somit auch eine Änderung der Verteilung der mechanischen Spannung über die Länge des Piezotranformators zur Folge. Daher ist es vorteilhaft, die Hilfselektroden an einer Position zu platzieren, an welcher die mechanische Spannung nur um einen kleinen Betrag schwankt, also z. B in einem endständigen Randbereich.

Die an der zusätzlichen Hilfselektrodenanordnung abgegriffene Spannung wird gemäß der vorliegenden Erfindung zur Energieversorgung der primärseitig angeordneten Regeleinrichtung verwendet. Hierbei kann die Fläche der Elektroden und damit die Kapazität dieser zusätzlichen Elektrodenanordnung den Energieverbrauch der Regeleinrichtung entsprechend angepasst werden.

Zum besseren Verständnis der vorliegenden Erfindung wird diese anhand der in den nachfolgenden Figuren dargestellten Ausführungsbeispiele näher erläutert. Dabei werden gleiche Teile mit gleichen Bezugszeichen und gleichen Bauteilbezeichnungen versehen. Weiterhin können auch einige Merkmale oder Merkmalskombinationen aus den gezeigten und beschriebenen unterschiedlichen Ausführungsformen für sich eigenständige Lösungen darstellen.

Es zeigen:
- **Fig. 1**: eine schematische Darstellung eines Piezotransformators mit primärseitigen und sekundärseitigen Elektrodenbereichen;
- **Fig. 2**: einen Piezotransformator mit zusätzlicher Elektrodenanordnung auf der Primärseite;
- **Fig. 3**: ein Blockschaltbild der Ansteuerschaltung sowie der Regelkreis eines Schaltnetzteils mit einem erfindungsgemäßen Piezotransformator;
- **Fig. 4**: eine weitere Ausführungsform einer Ansteuerschaltung für ein Schaltnetzteil mit dem erfindungsgemäßen Piezotransformator.

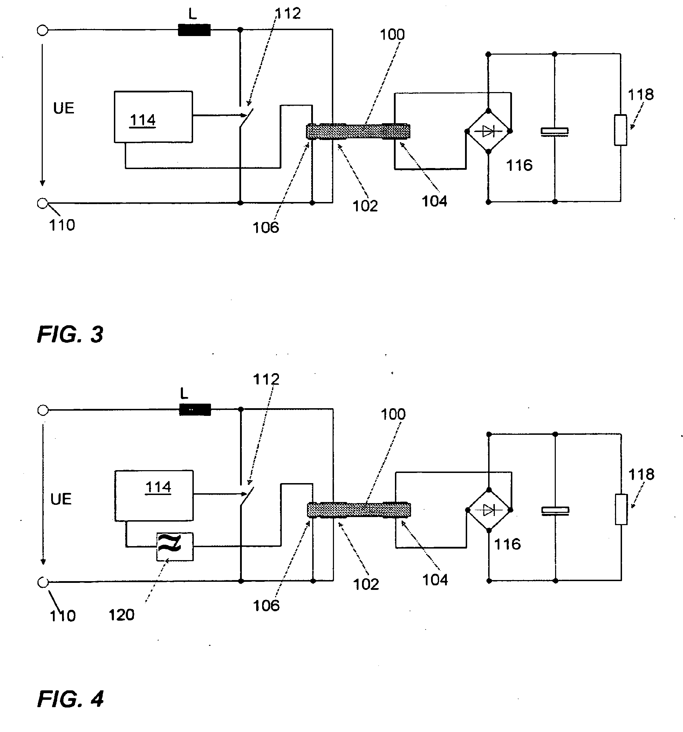

Mit Bezug auf Figur 2 soll im Folgenden der piezoelektrische Transformator 100 für ein erfindungsgemäßes Schaltnetzteil im Detail erläutert werden. Der piezoelektrische Transformator 100 umfasst, wie dies bekannt ist, einen Grundkörper 108, der aus einem piezoelektrischen Material besteht. Primärseitige Elektroden 102 wandeln eine primärseitige Spannung oder Eingangsspannung (siehe auch die Figuren 3 und 4) über den piezoelektrischen Effekt in eine mechanische Schwingung um.

Auf der Sekundärseite entsteht infolge der mechanischen Schwingung an sekundärseitigen Elektroden 104 eine transformierte Ausgangsspannung, wobei die Ausgangsspannung eine höhere oder eine niedrigere Spannung sein kann als die Eingangsspannung. Das heißt, die Funktionsweise des piezoelektrischen Transformators 100 kann als ein doppelter Wandlungsvorgang aufgefasst werden, bei dem eine erste piezoelektrische Wandlung elektrische Energie in mechanische Energie umsetzt und eine Rückwandlung der mechanischen Energie in elektrische Energie erfolgt. Wie in US 2,830,274 ausgeführt, wird dabei mechanische Energie aus einem ersten Bereich des piezoelektrischen Körpers 108, der mit den Eingangselektroden zusammenwirkt, an einen zweiten Bereich des piezoelektrischen Körpers, der mit den Ausgangselektroden zusammenwirkt, transferiert.

Zur erfindungsgemäßen Verwendung weist der in Figur 2 dargestellte Piezotransformator eine zusätzliche Elektrodenanordnung 106 auf, die sich die Tatsache zunutze macht, dass der erwähnte elektromechanische Wandlungsprozess auch in die Gegenrichtung erfolgt. Das heißt, an dem zusätzlich eingefügten Elektrodenpaar 106 lässt sich ein der Ausgangsspannung proportionales Signal abgreifen, welches bei Anwendung in einem Schaltnetzteil als Regelgröße für eine primärseitig angeordnete Regeleinrichtung verwendet werden kann.

Ein Blockschaltbild einer Ansteuerschaltung für den Piezotransformator 100 sowie der zugehörige Regelkreis sind in Figur 3 dargestellt. Dabei wird eine Eingangsspannung an die Eingangsklemmen 110 angelegt. Die Eingangsspannung ist weiterhin mit den primärseitigen Elektroden 102 verbunden. Ein Schalter 112, beispielsweise ein Transistor, wird von einem Regler 114 angesteuert. Erfindungsgemäß wird die an der zusätzlichen Elektrodenanordnung 106 abgegriffene Hilfsspannung dem Regler 114 als Regelgröße zugeführt. Der Regler 114 wertet dieses Signal aus und steuert den Schalter 112 entsprechend. An den sekundärseitigen Elektroden 104 kann die transformierte Ausgangsspannung abgegriffen, in einem Gleichrichter 116 gleichgerichtet und an einer Last 118 ausgegeben werden.

In der hier gezeigten speziellen Ausführungsform befindet sich die zusätzliche Elektrodenanordnung 106 auf der Primärseite des Piezotransformators 100. Damit kann die abgegriffene Spannung direkt ohne galvanische Trennung dem Regler zugeführt werden. Die Regelung der Ausgangsspannung erfolgt bei einem solchen Schaltnetzteil mit piezoelektrischem Wandler 100 durch Verändern der Arbeitsfrequenz. Entfernt man sich nämlich von der Resonanzfrequenz des piezoelektrischen Transformators 100, so verringert sich die auf die Sekundärseite übertragene Energie.

In Figur 4 ist eine weitere Ausführungsform der erfindungsgemäßen Lösung gezeigt. Hier wird zwischen der an der zusätzlichen Elektrodenanordnung 106 abgegriffenen Spannung und dem Regler 114 noch ein Filter geschaltet. Dieses Filter 120 ist als Tiefpass ausgeführt, sodass nur die Grundschwingung des piezoelektrischen Transformators 100 das Filter 120 passiert. Die Oberschwingungen, die angeregt werden können, werden herausgefiltert, wodurch die Proportionalität zwischen der Ausgangsspannung und der an der zusätzlichen Elektrodenanordnung 106 abgegriffenen Hilfsspannung verbessert wird.

Die an der zusätzlichen Elektrodenanordnung 106 abgegriffene Hilfsspannung ist abhängig vom Stand dieser beiden Elektroden zueinander. Sie ist zudem proportional zu der mechanischen Spannung innerhalb des piezoelektrischen Transformators 100. Über die gesamte geometrische Länge des Piezotransformators 100 ist diese mechanische Spannung nicht konstant, sondern sie wird durch eine Sinusfunktion beschrieben. Eine Änderung der Frequenz, mit welcher der Piezotransformator 100 angeregt wird, hat damit auf eine Änderung der Verteilung der mechanischen Spannung über die gesamte Länge des Piezotransformators 100 zur Folge. Daher ist es vorteilhaft, die Hilfselektroden 106 an einer Position zu platzieren, an welcher die mechanische Spannung nur um einen kleinen Betrag schwankt. Diese kann beispielsweise in einem Endbereich des Piezotransformators sein.

Gemäß einer erfindungsgemäßen Ausführungsform wird die an der zusätzlichen Elektrodenanordnung 106 abgegriffene Spannung außerdem zur Energieversorgung der primärseitig angeordneten Regeleinrichtung 114 verwendet. Hierzu kann die Fläche der Elektroden 106 und damit die Kapazität dieser zusätzlichen Elektrodenanordnung dem Energieverbrauch der Regeleinrichtung 114 entsprechend angepasst werden.

Der Piezotransformator mit Rückkoppelelektrode ermöglicht somit ein einfaches Übertragen der Information über die Höhe der Ausgangsspannung von der Sekundärseite auf die Primärseite. Ein Optokoppler inklusive der aufwändigen Peripheriebeschaltung kann entfallen, indem die Information über die Ausgangsspannung unmittelbar über den Piezotransformator übertragen wird. Damit kann erfindungsgemäß ein Schaltnetzteil mit einem Piezotransformator inklusive einer Primärregelung auf kleinstem Raum und mit einem Minimum an Bauteilen realisiert werden.

## Patentansprüche

1. Primärseitig gesteuertes Schaltnetzteil umfassend:
einen piezoelektrischen Transformator (100) zum Transformieren einer primärseitigen Spannung in eine sekundärseitige Spannung, wobei der piezoelektrische Transformator (100) eine primärseitige Elektrodenanordnung (102), die mit der primärseitigen Spannung verbindbar ist, eine sekundärseitige Elektrodenanordnung (104), an der die sekundärseitige Spannung abgreifbar ist, sowie eine Hilfselektrodenanordnung (106) zum Erzeugen einer der sekundärseitigen Spannung proportionalen Hilfselektrodenspannung umfasst, und wobei die Hilfselektrodenanordnung (106) durch mindestens zwei einander gegenüberliegende Flächenelektroden gebildet ist;
einen Schalter (112), der mit der primärseitigen Elektrodenanordnung (102) verbunden ist;
einen Gleichrichter (116) zum Gleichrichten der sekundärseitigen Spannung; und
eine Regelschaltung (114), die mit dem Schalter und der Hilfselektrodenspannung verbunden ist, wobei die Hilfselektrodenspannung als Regelgröße zum Regeln der Ausgangsspannung des Schaltnetzteils der Regelschaltung (114) zugeführt wird, und
wobei die Hilfselektroderispannung eine Versorgungsspannung des Primärstromkreises bildet.

2. Schaltnetzteil nach Anspruch 1, wobei die Hilfselektrodenanordnung (106) in einem Bereich des Transformators (100) angeordnet ist, in welchem eine frequenzabhängige mechanische Spannungsschwankung sich an einem Minimum einer sinusförmigen mechanischen Spannung des Transformators (100) befindet.

3. Schaltnetzteil nach Anspruch 1 oder 2, wobei die mindestens zwei Flächenelektroden der Hilfselektrodenanordnung (106) in einem Endbereich des Transformators (100) angeordnet sind.

4. Schaltnetzteil nach einem der vorhergehenden Ansprüche, wobei die Hilfselektrodenanordnung (106) auf der Primärseite des Transformators angeordnet ist.

5. Schaltnetzteil nach einem der vorhergehenden Ansprüche, wobei die Regelschaltung (114) so ausgeführt ist, dass sie die Ausgangsspannung durch Ansteuern des Schalters (112) zum Verändern der Arbeitsfrequenz des Transformators (100) regelt.

6. Schaltnetzteil nach Anspruch 5, wobei die Arbeitsfrequenz unterschiedlich von einer Resonanzfrequenz des Transformators ist.

7. Schaltnetzteil nach einem der vorhergehenden Ansprüche, wobei eine Induktivität (L) zwischen der Eingangsspannung und der primärseitigen Elektrodenanordnung (102) vorgesehen ist.

8. Schaltnetzteil nach einem der vorhergehenden Ansprüche, wobei der Schalter (112) einen Transistor umfasst, der von dem Regler (114) ansteuerbar ist.

9. Schaltnetzteil nach einem der vorhergehenden Ansprüche, wobei zwischen der Hilfselektrodenanordnung (106) und der Regelschaltung (114) eine Tiefpassfilterschaltung (120) angeordnet ist, die nur eine Grundschwingung der Transformators (100) passieren lässt und angeregte Oberschwingungen herausfiltert.

10. Schaltnetzteil nach einem der vorhergehenden Ansprüche, wobei die geregelte Ausgangsspannung niedriger ist als die Eingangsspannung.

11. Schaltnetzteil nach einem der Ansprüche 1 bis 9, wobei die geregelte Ausgangsspannung höher ist als die Eingangsspannung.

## Claims

1. Switching-mode power supply controlled from the primary side comprising:
a piezoelectric transformer (100) for transforming a primary side voltage to a secondary side voltage, which piezoelectric transformer (100) comprises a primary side electrode arrangement (102) which can be connected to the primary side voltage, a secondary side electrode arrangement (104) on which the secondary side voltage can draw, as well as an auxiliary electrode arrangement (106) for generating an auxiliary electrode voltage proportional to the secondary side voltage, the auxiliary electrode arrangement (106) being provided in the form of two mutually opposite flat electrodes;
a switch (112), which is connected to the primary side electrode arrangement (102);
a rectifier (116) for rectifying the secondary side voltage; and
a regulating circuit (114) which is connected to the switch and auxiliary electrode voltage, the auxiliary electrode voltage being fed to the regulating circuit (114) as a regulating variable for regulating the output voltage of the switching-mode power supply, and the auxiliary electrode voltage constitutes a supply voltage of the primary circuit.

2. Switching-mode power supply as claimed in claim 1, in which the auxiliary electrode arrangement (106) is disposed in a region of the transformer (100) in which a fluctuation in a sinusoidal mechanical stress of the transformer (100) dependent on frequency is at a minimum.

3. Switching-mode power supply as claimed in claim 1 or 2, in which the at least two flat electrodes of the auxiliary electrode arrangement (106) are disposed in an end region of the transformer (100).

4. Switching-mode power supply as claimed in one of the preceding claims, in which the auxiliary electrode arrangement (106) is disposed on the primary side of the transformer.

5. Switching-mode power supply as claimed in one of the preceding claims, in which the regulating circuit (114) is configured so that it regulates the output voltage by activating the switch (112) in order to change the working frequency of the transformer (100) .

6. Switching-mode power supply as claimed in claim 5, in which the working frequency is different from a resonance frequency of the transformer.

7. Switching-mode power supply as claimed in one of the preceding claims, in which an inductance (L) is provided between the input voltage and the primary side electrode arrangement (102).

8. Switching-mode power supply as claimed in one of the preceding claims, in which the switch (112) comprises a transistor which can be activated by the regulator (114).

9. Switching-mode power supply as claimed in one of the preceding claims, in which a low-pass filter circuit (120) is disposed between the auxiliary electrode arrangement (106) and the regulating circuit (114), which allows only a fundamental oscillation of the transformer (100) to pass through and filters out induced harmonic oscillations.

10. Switching-mode power supply as claimed in one of the preceding claims, in which the regulated output voltage is lower than the input voltage.

11. Switching-mode power supply as claimed in one of claims 1 to 9, in which the regulated output voltage is higher than the input voltage.

## Revendications

1. Alimentation à découpage commandée côté primaire comprenant :
un transformateur piézoélectrique (100) pour transformer une tension côté primaire en une tension côté secondaire, dans laquelle le transformateur piézoélectrique (100) comprend un ensemble d'électrodes (102) côté primaire qui peut être relié à la tension côté primaire, un ensemble d'électrodes (104) côté secondaire, sur lequel la tension côté secondaire peut être prélevée, ainsi qu'un ensemble d'électrodes auxiliaires (106) pour générer une tension d'électrode auxiliaire proportionnelle à la tension côté secondaire, et dans laquelle l'ensemble d'électrodes auxiliaires (106) est formé par au moins deux électrodes planes opposées ;
un interrupteur (112) relié à l'ensemble d'électrodes (102) côté primaire ;
un redresseur (116) pour redresser la tension côté secondaire ; et
un circuit de réglage (114) relié à l'interrupteur et à la tension d'électrode auxiliaire, la tension auxiliaire étant alimentée en tant que grandeur de réglage pour régler la tension de sortie de l'alimentation à découpage du circuit de réglage (114), et
la tension d'électrode auxiliaire formant une tension d'alimentation du circuit primaire.

2. Alimentation à découpage selon la revendication 1, dans laquelle l'ensemble d'électrodes auxiliaires (106) est disposé dans une zone du transformateur (100), dans laquelle une variation de tension mécanique dépendante de la fréquence se trouve au niveau d'un minimum d'une tension mécanique sinusoïdale du transformateur (100).

3. Alimentation à découpage selon la revendication 1 ou 2, dans laquelle les au moins deux électrodes planes de l'ensemble d'électrodes auxiliaires (106) sont disposées dans une zone d'extrémité du transformateur (100).

4. Alimentation à découpage selon l'une quelconque des revendications précédentes, dans laquelle l'ensemble d'électrodes auxiliaires (106) est disposé sur le côté primaire du transformateur.

5. Alimentation à découpage selon l'une quelconque des revendications précédentes, dans laquelle le circuit de réglage (114) est réalisé de telle sorte qu'il règle la tension de sortie en commandant l'interrupteur (112) pour modifier la fréquence de travail du transformateur (100).

6. Alimentation à découpage selon la revendication 5, dans laquelle la fréquence de travail est différente d'une fréquence de résonance du transformateur.

7. Alimentation à découpage selon l'une quelconque des revendications précédentes, dans laquelle une inductance (L) est prévue entre la tension d'entrée et l'ensemble d'électrodes (102) côté primaire.

8. Alimentation à découpage selon l'une quelconque des revendications précédentes, dans laquelle l'interrupteur (112) comprend un transistor qui peut être commandé par le circuit de réglage (114).

9. Alimentation à découpage selon l'une quelconque des revendications précédentes, dans laquelle un circuit de filtre passe-bas (120) qui ne laisse passer qu'une oscillation fondamentale du transformateur (100) et qui filtre les oscillations harmoniques excitées est disposé entre l'ensemble d'électrodes auxiliaires (106) et le circuit de réglage (114).

10. Alimentation à découpage selon l'une quelconque des revendications précédentes, dans laquelle la tension de sortie réglée est inférieure à la tension d'entrée.

11. Alimentation à découpage selon l'une quelconque des revendications 1 à 9, dans laquelle la tension de sortie réglée est supérieure à la tension d'entrée.
